Europäisches Patentamt

(19) European Patent Office

Office européen des brevets

(11) Publication number: 0 348 104
A2

## (12) EUROPEAN PATENT APPLICATION

(21) Application number: 89306082.2

(22) Date of filing: 15.06.89

(51) Int. Cl.⁴: H01L 39/24 , C04B 35/00

(30) Priority: 20.06.88 GB 8814636

(43) Date of publication of application:
27.12.89 Bulletin 89/52

(84) Designated Contracting States:
AT BE CH DE ES FR GB IT LI LU SE

(71) Applicant: IMPERIAL CHEMICAL INDUSTRIES PLC
Imperial Chemical House Millbank
London SW1P 3JF(GB)

(72) Inventor: Alford, Neil McNeil
49a Daleside
Upton Chester(GB)

(74) Representative: Walmsley, David Arthur Gregson et al
Imperial Chemical Industries PLC Legal department: Patents PO Box 6 Bessemer Road
Welwyn Garden City Hertfordshire AL7 1HD(GB)

(54) Production of superconducting article.

(57) A process for the production of an article of ceramic superconducting material in which a composition comprising a particulate ceramic superconducting material and organic material is mixed and shaped, the shaped composition is heated to remove the organic material, and the shaped composition is further heated to sinter the particles of ceramic superconducting material. The organic material may be an organic polymeric material which may be in the form of a solution in a liquid medium. The composition may be mixed and shaped under conditions of high shear, and the article may have a low surface resistance.

EP 0 348 104 A2

## PRODUCTION OF SUPERCONDUCTING ARTICLE

This invention relates to a process for the production of an electrically superconducting article by means of which such articles of both simple and complex profile may be produced, and in particular to the production of an article having an enhanced critical current density and, in a preferred form, a low surface resistance.

The phenomenon of superconductivity, that is the complete loss of electrical resistance of a material, has been known for many years. Many elements and alloys are known to possess the property of superconductivity, for example niobium and alloys of niobium, and superconductivity has generally been considered to be a property possessed by certain elements when in the metallic state. Whilst materials which possess the property of superconductivity potentially have very many applications, for example, in electrical power transmission lines which in use result in little or no loss of power, in electric motors, in magnetic levitation applications such as in transportation systems which operate on the magnetic levitation principle, in scientific instruments, e.g. in superconducting quantum interference devices (SQUIDS), and in structures for use in magnetic screening, e.g. in the screening of electrical equipment, the application of such materials has been severely limited as until recently superconductivity could be attained only at extremely low temperatures. The temperatures at which superconductivity could be attained, that is the critical temperature, Tc, were generally below 23K and such temperatures can be attained only by using liquid helium as a coolant. Such extremely low temperatures, and the expense of liquid helium as a coolant, limited the practical application of the phenomenon of superconductivity to uses in scientific instruments, such as in as nuclear magnetic research scanners.

In a more recent development the phenomenon of superconductivity has been observed in certain materials at substantially higher temperatures than those at which superconductivity has been observed hitherto and which are attainable only by cooling with liquid helium. In particular, the phenomenon of superconductivity has been observed at temperatures as high as 77K, or even higher, that is at temperatures which are attainable by cooling with liquid nitrogen. The fact that superconductivity is attainable at such relatively high temperatures, and the fact that the required coolant is the relatively inexpensive liquid nitrogen, has opened up the possibility of much more widespread practical applications of the phenomenon of superconductivity than have been possible hitherto.

In Z. Phys. B. - Condensed Matter, 64, pp 189-193 (1986) J. G. Bednorz and K. A. Muller reported the preparation of coprecipitated and heat treated mixtures of lanthanum, barium, copper and oxygen and they reported that the mixtures showed superconductivity at a critical temperature higher than the critical temperatures which had been observed hitherto for metals and alloys. The mixtures were reported to have composition $La_{5-x} Ba_x Cu_5 O_{5(3-y)}$ Where $x = 0.75$ to 1 and $Y > 0$ and the compositions were prepared by coprecipitation from barium, lanthanum and copper nitrate solutions by addition to an oxalic acid solution followed by decomposition and solid state reaction at 900°C for 5 hours and sintering in an oxygen atmosphere.

In published European Patent Application 0 275 343 there is described a superconductive compound having a critical temperature above 28K, and which may be as high at 35K. The compound is of the $RE_3TMO_4$ type wherein the rare earth element (RE) is partially substituted by one or more alkaline earth metal elements (AE) and wherein the oxygen content is adjusted such that the resulting crystal structure is distorted and comprises a phase of the general compositions $RE_{2-x} AE_xTMO_{4-y}$, wherein TM represents a transition metal and $x < 0.3$ and $y < 0.5$. A favoured rare earth element is lanthanum, a favoured alkaline earth · element is barium, and a favoured transition metal is copper.

In International Patent Application No. PCT/US 87/02958, International Publication No. WO 88/05029, there is described a composition which is superconducting at a temperature of 40K and higher, and which comprises a sintered metal oxide complex of the formula

$[L_{1-x}M_x]_aA_bO_y$

in which L is yttrium, lanthanum, cerium, preasodymium, neodymium, samarium, europium, gadolinium, terbium, dysprosium, holmium, erbium, thulium, ytterbium, or lutetium, or a combination thereof, M is barium strontium, calcium, magnesium, mercury, or a combination thereof, provided that when L is lanthanum M is not barium, A is copper, bismuth, tungsten, zirconium, tantalum, niobium, or vanadium, x is from about 0.01 to 1.0, a is 1 to 2, b is 1, and y is about 2 to 4.

In the aforementioned International Publication there is also described the production of the sintered metal oxide complex by heating a mixture of solid compounds containing L, M, A and O in proportions appropriate to yield the aforementioned formula to a temperature of 640-800°C in an oxygen atmosphere and for a time sufficient to react the mixture in the solid state and then heating the mixture at 900-1100°C for a period of at least about 12 hours subsequent to the reaction, pelletizing the mixture, and sintering the pellets. With certain of the sintered metal oxide complexes a critical temperature as high as 100K has been observed. A preferred sintered metal oxide complex is that in which L is yttrium, M is barium and A is copper and one phase of such a preferred material which has been identified as having a high critical temperature is that having the empirical formula $YBa_2Cu_3O_x$ where x is typically between 6.5 and 7.2, generally about 7.

The materials which exhibit superconductivity at such relatively high temperatures are ceramic materials which are relatively easy to make and which are relatively inexpensive.

Thus the ceramic materials may be produced by forming a mixture of the oxides of the required elements, and/or of precursors for these oxides, e.g. carbonates and/or nitrates, in the required proportions, heating the mixture at an elevated temperature in an oxygen-containing atmosphere, e.g.at a temperature of $900^\circ$ C to $950^\circ$ C or higher in air, for a time which is of the order of 12 to 24 hours, and subsequently cooling the thus formed ceramic material and if necessary grinding the material to convert it into a particulate form.

Articles may be produced from the particulate ceramic superconducting materials by processes which are conventional in the ceramics processing art, for example, by shaping the particulate ceramic superconducting material by powder pressing, by isostatic pressing, or by slip casting, and thereafter sintering the material. For example, the particulate ceramic superconducting material may be pressed in a mould into a desired shape at elevated pressure and the material may be heated at elevated temperature in an oxygen-containing atmosphere, e.g. in air at a temperature of the order of 900 to $950^\circ$ C or higher, in order to sinter together the particles of ceramic material. The thus sintered material may then be cooled slowly to ambient temperature in an oxygen-containing atmosphere, and during the cooling process the article may be annealed, for example at a temperature of approximately $400^\circ$ to $450^\circ$. In an alternative process the particulate ceramic superconducting material may be replaced by the oxides of the required elements, and/or by precursors for these oxides, and the above described shaping, heating and cooling procedures may be followed.

Articles produced from such particulate superconducting ceramic materials by processes as described suffer from a substantial disadvantage in that they have a critical current density, that is a maximum current carrying capacity, which is not as great as may be desired, e.g. a critical current density of the order of 100 to at most 500 Amp/cm², and generally much less,depending on the method by which the article is produced, although certain highly specialised techniques, such as growth of single crystals from a melt, have resulted in critical current densities of several thousand Amp/cm². It is particularly desirable that the critical current density of articles produced from such particulate ceramic superconducting materials should be increased, and should be as high as possible, otherwise the applications of such articles may be somewhat limited.

The present invention relates to a process for the production of an article of superconducting ceramic material which is simple to operate and by means of which articles of both simple and complex profile may be produced, and which results in an article of enhanced critical current density when compared with an article produced by processes which are conventional in the ceramics processing art. In a preferred form the article produced in the process may also have a low surface resistance.

According to the present invention there is provided a process for the production of an article of a ceramic superconducting material in which a composition comprising a particulate ceramic superconducting material, or a particulate mixture of precursors of said material, and a solid organic material is mixed and shaped, the shaped composition is then heated to remove the organic material, and the shaped composition is further heated,if necessary to convert the said precursors into the said superconducting material, and to sinter the particles of ceramic superconducting material.

Mixing and shaping of the composition is preferably effected under conditions of shear, particularly of high shear, such as can be achieved by use of plastics and rubber processing techniques, eg by extrusion through a narrow die and by calendering between rotating rollers, as it is believed, without prejudice, that shaping of the aforementioned composition under conditions of shear results in some orientation of those planes of the particles of ceramic superconducting material through which electrical current flows more readily. This orientation is believed to result in the enhancement of the critical current density of the article produced by the process of the invention. Techniques by which mixing and shaping under conditions of shear may be effected will be described in more detail hereafter. However, although it is difficult to be quantitative regarding the nature of "high shear" mixing and shaping of the composition we have found that the high shear mixing may be of such intensity, particularly when the composition is a preferred composition as hereafter described, that the critical current density of the article produced in the process of the invention may be at least 500 amps cm$^{-2}$, or even at least 1000amps cm$^{-2}$.

3

The shaped article of the invention may be produced from any suitable particulate superconducting material or from precursors therefor, but it is preferred that the superconducting material is a material which itself exhibits superconductivity at a relatively high temperature, that is which has a relatively high critical temperature, and specifically that it be superconducting at a temperature which is not lower than the boiling point of nitrogen at normal temperature and pressure, that is at temperature which is not lower than 77K. Such materials are preferred as the coolant which is required in order to attain superconductivity in the shaped article, liquid nitrogen, is relatively inexpensive when compared with coolants such as liquid helium which are required when the particulate material in the shaped article of the invention exhibits superconductivity only at much lower temperatures. Furthermore, where the material exhibits superconductivity at the temperatures of liquid nitrogen there are potentially much more widespread practical applications for shaped articles comprising the particulate superconducting material. However, the use of particulate materials which exhibit superconductivity and thus have a critical temperature only at temperatures lower than 77K is not excluded from the invention.

Preferred particulate superconducting materials are the ceramic materials of the oxide type and which comprise at least one element of the lanthanide series, including lanthanum itself, scandium and/or yttrium, at least one alkaline earth element, e.g. magnesium, calcium, strontium, or barium, and at least one transition element, e.g. copper, titanium, tungsten, zirconium, tantalum, niobium, or vanadium. The particulate superconducting material may have a formula as hereinbefore referred to with respect to International Publication No. WO 88/05029, and indeed in the aforementioned formula when L is lanthanum M may be barium.

A particulate supeconducting material which is preferred as it has a particularly high critical temperature is a yttrium-barium-copper oxide material, for example, the material having the composition $YB_aCu_3O_x$ where x is between 6.5 and 7.2 generally about 7, as this material has a high critical temperature, which may be above the boiling point of liquid nitrogen, that is above 77K. Another particulate superconducting material of the oxide type which may be mentioned is that comprising lanthanum-barium-copper oxide, although the invention is not limited to use with any specific superconducting material of the ceramic type, nor to any specific such material of the oxide type, and many such materials may be used in the production of the shaped article of the invention. Other examples of suitable particulate superconducting materials are described in the published literature, e.g. in Australian patent application 88 14255, and in published European patent applications 287749 and 287810. Another example is Japanese Patent Publication 63230564 which discloses a material

$(A_{1-x}B_x)_y CUO_2$ where x = 0.01 - 0.3, y = 1.3 - 2.2, z = 2.0 - 4.0, A = Ge, Zr, Nb or Ge and B = Ba or Sr.

It is to be understood that in the particulate superconducting material used in the production of the shaped article several distinct phases may be present some of which may be superconducting and some of which may not be superconducting.

Methods for producing the particulate superconducting material which forms a part of the composition from which the shaped article is produced are described in the literature. Such superconducting materials of the oxide type may be produced in particulate form by forming a mixture of the oxides of the desired elements in the the required proportions, and/or a mixture of decomposible precursors of the oxides of the desired elements, e.g. a mixture of carbonates and/or nitrates, heating the mixture at an elevated temperature in an oxygen-containing atmosphere, e.g. at a temperature of 900 to 950° C or higher in oxygen, for a time which is of the order of 12 to 24 hours, and subsequently cooling the thus formed ceramic material, preferably in an oxygen atmosphere, and grinding the material to convert it into the desired particulate form.

Where the composition comprises precursors of the superconducting material in particulate form the precursors may be oxides of elements which are to be present in the material, and/or precursors which are thermally decomposible to oxides, e.g. carbonates and/or nitrates.

The particulate superconducting material, or the precursors therefor, may have any convenient particle size provided that the sizes of the particles, and the distribution of particle sizes, is such that the particles can be mixed homogeneously with the organic material and shaped to form the shaped article of the invention. A suitable particle size is not greater than 500 microns preferably not greater than 100 microns, for example a size in the range 100 to 0.001 microns, e.g. 0.01 to 10 microns. The particulate superconducting material or the precursors therefor may have a plurality of particle sizes, and such a plurality of sizes is especially important in the achievement of good particle packing and consequently a high proportion of particulate material in the composition and in the shaped article which is produced in the process of the invention.

The organic material in the composition is a solid organic material, that is a material which is solid at ambient temperature, and it will generally be an organic polymeric material as such materials are suitable for use in shaping processes in which shear is applied to the composition. Suitable polymeric materials include thermoplastic organic polymeric materials, for example polyolefins, e.g. polyethylene or polyproplyene; polyamides, for example a nylon, e.g. nylon-6 or nylon-12; a polyester; or an acrylic polymer, e.g. polymethyl methacrylate; or a polyvinyl halide, e.g. polyvinyl chloride.

A preferred composition, which may readily be subjected to mixing, and shaping, under conditions of high shear in order to produce a thoroughly homogeneously mixed composition, is a composition which comprises particulate superconducting material, or a particulate mixture of precursors therefor, an organic polymeric material, and a liquid medium in which the organic polymeric material is soluble. Where such a composition is used in the process of the invention the composition is shaped and then heated to remove the liquid medium and the organic polymeric material from the composition, and it is further heated, if necessary to convert the precursors to the superconducting material, and to sinter the particles of superconducting material.

The liquid medium in this preferred composition will generally be an organic liquid as water may react with the superconducting material. Examples of organic liquid media include ketones, ethers, e.g. cyclic ethers, and acetates. Specific examples include cyclohexanone, tetrahydrofuran, and ethyl acetate,

Examples of organic polymers for use in this preferred composition include acetate polymers and copolymers, hydrolysed acetate polymers and copolymer, acrylate and methacrylate polymers and copolymers, polymers and copolymers of ethylenically unsaturated acids, and vinyl halide polymers and copolymers. Specific examples of organic polymers and liquid media which may be mentioned include

 (1) Methylmethacrylate/dimethylaminoethylmethacrylate copolymer in ethyl acetate

 (2) Styrene/acrylontrille copolymer in tetrahydrofuran,

 (3) Vinyl chloride/vinyl acetate/vinyl alcohol copolymer in tetrahydrofuran,

 (4) Vinyl acetate/crotonic acid copolymer in tetrahydrofuran,

 (5) Vinylidene chloride/acrylontrile copolymer in tetrahydrofuran, and

 (6) Vinyl butyral/vinyl alcohol copolymer in cyclohexanone.

As the organic material, and the liquid medium if present, have to be removed from the shaped composition it is preferred that the composition which is shaped comprises a high proportion of particulate ceramic superconducting material or precursors therefor and a low proportion of organic material and liquid medium, for example at least 40% of particulate ceramic superconducting material or precursors therefore by volume of the composition preferably at least 50% by volume, more preferably at least 60% by volume.

Where the composition comprises an organic polymeric material and a liquid medium these components may be present in the composition in proportions of for example, 5 to 40% by volume and 5 to 40% by volume respectively.

Mixing and shaping of the composition is preferably effected under conditions of high shear in order that the components of the composition may be homogeneously mixed and in order that the article produced from the composition shall have a high critical current density, and in particular, a critical current density higher than that in an article produced from a composition which has not been mixed and shaped under conditions of high shear and which has been produced by a conventional process, e.g. by compressing and sintering the particles of superconducting material. Use of high shear mixing also has the added benefit that the shaped article which is produced has a high strength. High shear mixing and shaping processes include extrusion and calendering. For example where a composition is extruded through a narrow orifice high shear may be imparted to the composition, particularly where the orifice has a narrow opening and is relatively long. A particularly high shear may be imparted to the composition where the composition is calendered between a pair of rolls rotating at different peripheral speeds, especially when the size of the nip between the rolls is progressively decreased. Although it will be dependent to some extent on the particle size of the superconducting material, or of the precursors therefore the orifice of the extruder may have a diameter of as little 0.1mm, or even as little as 0.01mm, and similarly the nip between a pair of rotating rolls may be as small as 0.1mm, in order that high shear may be imparted to the composition during the mixing and shaping.

A preferred composition from which a shaped composition of simple or complex profile may readily be produced, is a composition of the type described in US patent 4677082. The composition may comprise at least 50% by volume of particulate superconducting material, or precursors therefor, at least one organic polymer, and a liquid medium, and the composition may have a friction coefficient of less than 0.2 and in the composition the particulate material may have a mean aspect ratio of less than 1.7. The disclosure of the US patent is incorporated herein by reference.

Where a particularly high strength article is desired it is preferred that the composition is subjected to high shear mixing of such intensity that the mean maximum size of flaw in the body which is ultimately produced, as determined by microscopic examination is less than 25 microns. The production of articles of sintered particulate ceramic material having such a mean maximum flaw size is described in European patent publication No. 0288208

Shaping of the composition may be effected by known plastics or rubber processing techniques, especially when the composition comprises a thermoplastic organic polymeric material or a solution of an organic polymeric material in a liquid medium. Suitable shaping techniques include injectionmoulding, extrusion and calendering.

The precise conditions to be used in the mixing and shaping steps, and in particular the precise temperature to be used will depend on the nature of the organic material in the composition. For example, where the composition comprises an organic polymeric material the mixing and shaping temperature will be above that at which the organic polymeric material is fluid. On the other hand, where the composition comprises a solution of an organic polymeric material in a liquid medium the mixing and shaping may be effected at or near ambient temperature.

The shaping step of the process of the invention may be used to produce articles having a variety of different shapes. In general, articles of more complex shape may be produced by injection moulding, whereas articles of more simple shape, e.g. films, sheets, wires, wires in the form of a coil, and rods may be produced by extrusion, or in the case of films and sheets by calendering.

In a preferred embodiment of the process, which results in a further and in many cases a substantial enhancement of the critical current density in the article produced in the process, the shaped composition is compressed prior to the heating step in which the particles of precursor, if present, are converted to superconducting material and in which the particles of superconducting material are sintered. Compression is preferably effected prior to the heating step in which the organic material, and liquid medium if present, are removed from the shaped composition. It is believed, without prejudice, that compression of the shaped composition results in further orientation of the particles of ceramic superconducting material, and in particular results in further orientation of those planes of the superconducting material through which electrical current flows more readily. In this preferred embodiment of the process the composition should of course be capable of being compressed, and in order to facilitate the compression the organic material, when a polymeric material, is preferably a thermoplastic, and the cross-linking in the organic polymeric material, if any, is preferably not such as to hinder the compression step. A composition comprising an organic polymeric material in solution in a liquid medium is more readily compressed and for this reason such a composition is preferred. Where the composition comprises on organic polymeric material in the absence of a liquid medium the organic polymeric material is preferably in a slightly softened state during the compression step, as brought about for example by moderate heating, as this assists the compression and the orientation of the particles of superconducting material. The orientation which is brought about by the compression should be retained in the thus compressed composition in order that the critical current density in the resultant product should be enhanced. Should the organic polymeric material be in a liquid state during, and particularly after application of the compressing force the orientation which may have been brought about by compression may be lost, and in the resultant article there may be a little or no enhancement of the critical current density.

Particular forms of shaped composition for use in the compression step are preferred. Thus, it is much preferred that the shaped composition has a minimum dimension which is substantially less than the maximum dimension of the shaped composition as shaped compositions of such a form are readily subjected to compression and with such shaped compositions it is possible to effect a substantial further enhancement of the critical current density of the article which is ultimately produced. For example, the shaped composition may be in the form of a wire or rod, which may be produced by extrusion of the composition, and which may have a diameter which is substantially less than its length. An alternative form of shaped composition may be a sheet or film, which may also be produced by extrusion, and which may have a thickness which is substantially less than its length and/or width. It is desirable that the shaped composition which is compressed in the process of the invention has a minimum dimension of not more than 5mm, preferably not more than 1mm. The minimum dimension of the shaped composition will usually be greater than 10 microns, generally greater than 50 microns.

Compression of the shaped composition may be effected in a variety of different ways. For example, the shaped composition may be compressed in a mould, e.g. a hydraulic press, or it may compressed between pair of rotating rollers. In the case where the shaped composition is in the form of a wire or rod it will thus be converted into the form of a strip. The extent of the compression which is effected governs to some extent the enhancement in the critical current density in the article which is ultimately produced. For this reason it is preferred that the minimum dimension of the composition after compression should be less than 50%, more preferably less than 20%, of the minimum dimension of the shaped composition before compression.

In a further stage by which the article is produced the shaped composition is heated in order to remove the organic material, and liquid medium if present, from the composition. The temperature to which the composition is heated will depend to some extent on the nature of the organic material, and the liquid medium if present, in the composition, but in general a temperature of 300 to 500°C will suffice, although the temperature to use with a composition containing a particular organic material, and liquid medium if present, may be chosen by simple experiment.

After removal of the organic material, and the liquid medium if present, from the composition the composition may then be heated in order to sinter the particles of ceramic superconducting material, and if necessary convert the precursors to superconducting material. The composition may be heated at elevated temperature in an oxygen-containing atmosphere, e.g. in air or in oxygen at a temperature of the order of 900 to 1000°c or higher, in order to so convert the precursors and sinter together the particles of ceramic superconducting material. The resultant product may then be cooled slowly to ambient temperature in an oxygen-containing atmosphere, and during the cooling step the article may be annealed, for example at a temperature of approximately 400°C to 450°C.

Use of the term "sintering" is intended to include the fusing together of particles of ceramis superconducting material in a solid state reaction or by a process which may include at least partial melting of the particles.

It is a surprising feature of the article produced by the process of the invention, and particularly of an article produced from a composition which comprises an organic polymeric material in solution in a liquid medium, and in particular of an article which has been produced by extrusion of a composition, especially through a narrow orifice, that the article has a low surface resistance. This is of particular importance when the article is used in radio frequency and microwave devices as the losses associated with the use of such an article are much reduced as a result of the low surface resistance. Shaped articles produced from particulate ceramic oxide superconducting materials by conventional processes, e.g. by compressing the particles in a mould and heating the compressed particles to sinter the particles, have a surface resistance when measured at a frequency of the order of 1000MHz and at a temperature below the critical temperature (Tc) which is not greatly different from the surface resistance at the same temperature and frequency of measurement an article of copper having the same shape and dimensions. Surprisingly, the shaped article produced by the process of the present invention has a surface resistance which is substantially less than that of an article of copper having the same shape and dimensions, although this low surface resistance is frequency dependent.

In a further embodiment of the present invention there is provided a shaped article of a superconducting material which has a surface resistance at a temperature below the critical temperature (Tc), eg at 77K and at frequencies upto 3000MHz which is equal to or less than one third, preferably equal to or less than one tenth, of the surface resistance at the same temperature and frequency of a shaped article of copper having the same shape and dimensions.

Uses for the shaped article produced in the process of the invention include uses in power transmission lines which in use result in little or no loss of power, in electric motors, in magnetic levitation applications such as transportation systems which operate on the magnetic levitation principle, in scientific instruments, e.g. in superconducting quantum interference devices (SQUIDS), in structures for use in magnetic screening, e.g. in the screening of electrical equipment, and in radio frequency and microwave devices.

The invention is now described with the aid of the following examples.

EXAMPLE 1

A particulate mixture of $BaCO_3$, $CuO$, and $Y_2O_3$ in proportions by weight of 52.9:32.0:15.1 was charged to a plastic container together with ethanol and the mixture was mixed and ground on a vibro energy mill using zirconia as a grinding medium. The mixture was removed from the plastic container and dried on a rotary evaporator and then heated in a furnace in an atmosphere of air at a temperature of 900°C for 12 hours. The mixture was then removed from the furnace and reground using the above-described procedure until the resulting particulate material had a surface area as measured by the BET method in the range 1 to 6 $m^2g^{-1}$. The particulate material had a particle size in the range 0.001 to 5 microns and had a composition, as determined by X-ray diffraction, of $YBa_2Cu_3O_x$

100 parts by weight of the particulate material were mixed with 7 parts by weight of polyvinyl butyral and with 10.5 parts by weight of cyclohexanone, and the viscous composition was passed repeatedly through the nip between the rolls of a twin-roll mill at ambient temperature. The composition which adhered to one of the rolls of the mill was repeatedly removed from the roll, turned at right angles, and passed back through the nip in order to produce a homogeneously mixed composition. During the mixing procedure on the twin-roll mill some of the cyclohexanone evaporated.

The sheet which was produced on the twin roll mill was removed from the mill, chopped into small pieces, charged to a ram extruder, and extruded in the form of a 1 mm diameter wire. The wire was then heated in an oven to evaporate the cylcohexanone, then at 450°C for 60 minutes to burn off the polyvinyl butyral, and finally the wire was heated in an atmosphere of oxygen at 920°C for 10 hours to sinter the particles of ceramic superconducting material and the oven and contents were cooled to 400°C in an atmosphere of oxygen at a rate of 1°C per minute. The temperature of the oven was then held at 400°C for 15 hours and finally it was cooled to ambient temperature at a rate of 1°C min$^{-1}$. The value of x in $YBa_2 Cu_3 O_x$ was 7.0 as determined by thermogravimetric analysis.

The ends of a portion of the wire were then coated with silver and connected to a source of electrical current and cooled to the temperature of liquid nitrogen and an electrical current was passed through the wire. The wire was found to be superconducting. The electrical current was gradually increased and the critical current density at which the wire was no longer superconducting was determined by a direct 4-point measurement in zero applied magnetic field. The critical current density was 800 Amps cm$^{-2}$.

By way of comparison a sample of particulate ceramic superconducting material produced as described above was compressed in a mould and heated in order to sinter the particles following the above described procedure. The critical current density of the article which was produced was 200 Amps cm$^{-2}$.

## EXAMPLE 2

The procedure described in Example 1 was repeated except that, prior to the heating steps, the 1 mm diameter wire was passed through the nip between a pair of rotating rollers at ambient temperature and compressed into the form of a strip 200 microns thick and 1.4 mm wide. The strip had a critical current density of 1000 Amps cm$^2$.

## EXAMPLE 3

The procedure of Example 1 was followed in five separate experiments except that the compositions were extruded through dies of diameters 3mm, 2mm, 1mm, 0.5mm and 0.4mm respectively and the wires which were produced following the heating procedure had diameters of 2.4mm, 1.55mm, 0.76m, 0.34mm and 0.29mm respectively. The critical current densities of the wires, determined following the procedure described in Example 1, were 265, 344, 661, 1652 and 1892 amps cm$^{-2}$ respectively.

## EXAMPLE 4

The procedure of Example 1 was followed to produce a particulate superconducting material except that the material was produced from a particulate mixture of $Bi_2O_3$, PbO, $S_r(NO_3)_2$, CaO and CuO in proportions by weight of 22.69: 14.49: 34.35:9.10: 19.32, and the temperature at which the particles in the mixture were heated in an atmosphere of air for 12 hours was 800°C rather than 900°C.

The particulate superconducting material had a composition $Bi_{1.2} Pb_{0.8} Sr_2 Ca_2 Cu_3 O_x$.

The procedure of Example 1 was followed to produce a wire of sintered particles of the superconducting material except that instead of heating in oxygen at 920°C for 10 hours the wire was heated in air at 850°C for 50 hours. The wire had a critical current density of 465 amps cm$^{-2}$.

By way of comparison the comparative procedure of Example 1 was repeated by compressing a sample of the particulate superconducting material in a mould and sintering the particles, except that instead of heating in oxygen at 920°C for 10 hours the sample was heated in air at 850°C for 50 hours. The critical current density of the article which was produced was 21.6 amps cm$^{-2}$.

## EXAMPLE 5

The procedure of example 1 was repeated to produce a wire of sintered ceramic superconducting material. The wire was then installed as an inner conductor in a quartz tube to which nitrogen gas was introduced and the tube was sealed by means of epoxy plugs. The quartz tube was installed in a copper pipe,as an outer conductor, to form a coaxial resonator. The surface resistance of the wire of sintered ceramic material was determined at 77K by the procedure described in Advanced Ceramics Vol. 3 No. 5 1988 page 522-523 over a frequency range up to 20 GHz. In this determination the value of Q, the quality factor was first determined, and the surface resistance was then determined from the relationship

$$Q = \omega\mu_0 \cdot \frac{\log \frac{\emptyset \text{ ex}}{\emptyset \text{ int}}}{\frac{2 R_s \text{ ex}}{\emptyset \text{ ex}} + \frac{2 R_s \text{ int}}{\emptyset \text{ int}}}$$

see Labeyrie M, Korman, R, and Mage J.C. in Journées d'études 13-14 Sep 1988 à l'ISMRA, Caen pp 179-182.

Where W = 2Πf where f is frequency

$\mu_0$= permeability of free space = 4Π x 10$^{-7}$

$R_S$ ext = surface resistance at outer pipe

$R_S$ int =    "       "      " inner conductor

$\emptyset$ ex = diameter of outer conductor

$\emptyset$ int =    "    " inner    "

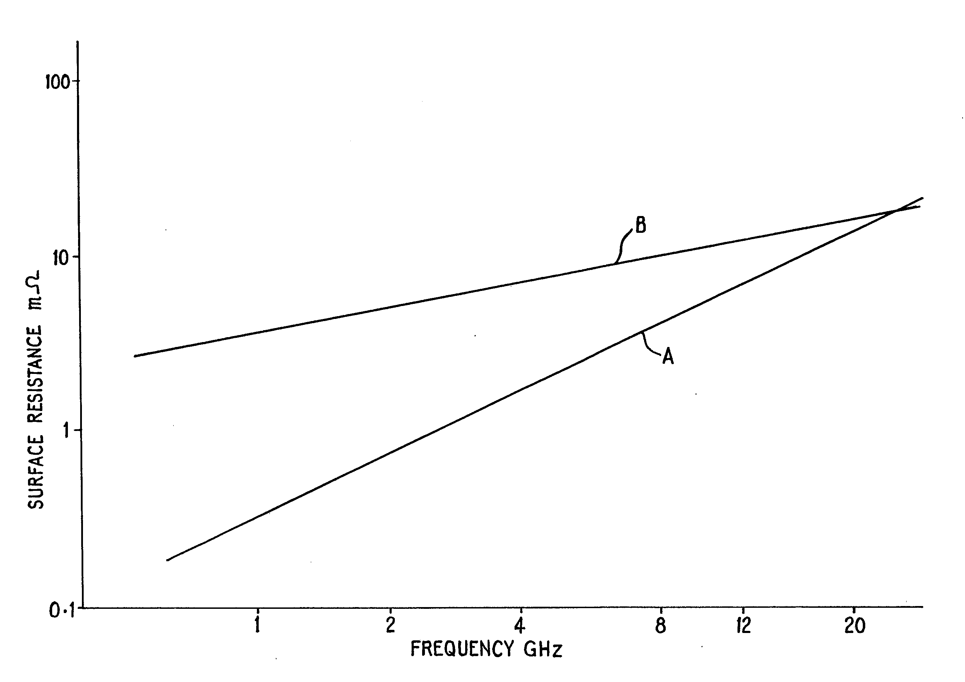

The variation of surface resistance of the wire of sintered ceramic material with frequency is shown in Figure 1 (A).

For the purposes of comparison the above surface resistance measurement procedure was repeated except that the wire of sintered ceramic superconducting material was replaced by a copper wire of the same dimensions. The variation of surface resistance of the copper wire over a frequency range up to 10 GHz is shown in Figure 1. (B).

## Claims

1. A process for the production of an article of a ceramic superconducting material in which a composition comprising a particulate ceramic superconducting material, or a particulate mixture of precursors of said material, and a solid organic material is mixed and shaped, the shaped composition is heated to remove the organic material, and the shaped composition is further heated, if necessary to convert the said precursors into the said superconducting material, and to sinter the particles of ceramic superconducting material.

2. A process as claimed in claim 1 in which the organic material is an organic polymeric material.

3. A process as claimed in claim 2 in which the composition comprises particulate superconducting material, or a particulate mixture of precursors therefor, and organic polymeric material, and a liquid in which the organic polymeric material is soluble.

4. A process as claimed in any one of Claims 1 to 3 in which the composition is mixed and shaped under conditions of high shear.

5. A process as claimed in claim 4 in which the composition is calendered and/or extruded.

6. A process as claimed in any one of claims 1 to 5 in which the shaped composition is compressed prior to the heating step in which the particles of precursor if present are converted to superconducting material and in which the particles of superconducting material are sintered.

7. A process as claimed in claim 5 or claim 6 in which the shaped composition is compressed prior to the heating step in which the organic material, and liquid medium if present, are removed from the composition.

8. A process as claimed in any one of claims 5 to 7 in which the shaped composition which is compressed has a minimum dimension which is substantially less than the maximum dimension of the shaped composition.

9. A process as claimed in claim 8 in which the shaped composition has a minimum dimension of not more than 5mm.

10. A process as claimed in any one of claims 5 to 9 in which the shaped composition is in the form of a wire, rod, sheet or film.

11. A process as claimed in any one of claims 5 to 10 in which the minimum dimension of the composition after compression is less than 50% of the minimum dimension of the shaped composition before compression.

12. A process as claimed in any one of claims 1 to 11 in which the superconducting material is a ceramic material of the oxide type.

13. A process as claimed in claim 12 in which the superconducting material comprises at least one element of the lanthanide series, scandium and/or yttrium, at least one alkaline earth element, and at least one transition element.

14. A process as claimed in claim 12 or claim 13 in which the superconducting material has the composition $YBas_2 Cu_3 O_x$ where x is between 6.5 and 7.2

15. A process as claimed in any one of claims 1 to 14 in which the superconducting material has a critical temperature which is not less than 77K.

16. A process as claimed in any one of claims 1 to 15 in which the superconducting material or the precursors therefor has a particle size in the range 0.001 to 100 microns.

17. A process as claimed in any one of claims 3 to 16 in which the liquid medium is an organic liquid.

18. A process as claimed in any one of claims 1 to 17 in which the composition comprises at least 40% by volume of particulate superconducting material.

19. A process as claimed in claim 18 in which the composition comprises at least 50% by volume of particulate superconducting material.

20. A process as claimed in any one of claims 1 to 19 in which the organic material, and the liquid medium if present, are removed from the shaped composition by heating the shaped composition at a temperature in the range 300°c to 500°C.

21. A process as claimed in claim 20 in which the composition is heated at a temperature in the range 900°C to 1000°C in an oxygen-containing atmosphere to sinter the particles of superconducting material, and if necessary convert the precursors to superconduting material.

22. An article of a ceramic superconducting material produced by a process as claimed in any one of claims 1 to 21.

23. A shaped article of superconducting material which has a surface resistance at a temperature below the critical temperature and at a frequency up to 3000 MHz which is equal to or less than one third of the surface resistance at the same temperature and frequency of a shaped article of copper having the same shape dimensions.

24. A shaped article as claimed in claim 23 which has a surface resistance equal to or less than one tenth of that of a shaped article of copper.

SURFACE RESISTANCE mΩ

FREQUENCY GHz

A

B